# EUROPÄISCHE PATENTSCHRIFT

(11) **EP 1 766 674 B1**
(45) Veröffentlichungstag und Bekanntmachung des Hinweises auf die Patenterteilung: **03.09.2008**
(21) Anmeldenummer: 05778282.3
(22) Anmeldetag: 11.07.2005
(51) Int. Cl.: H01L 21/60

(54) **Verfahren und Vorrichtung zur wechselseitigen Kontaktierung von zwei Wafern**
Method and device for the alternate contacting of two wafers
Procédé et dispositif permettant la mise en contact mutuel de deux plaquettes

(30) Priorität: 15.07.2004 DE 102004034421
(43) Veröffentlichungstag der Anmeldung: 28.03.2007
(73) Patentinhaber: Pac Tech - Packaging Technologies GmbH, 14641 Nauen (DE)
(72) Erfinder: ZAKEL, Elke, 14612 Falkensee (DE); AZDASHT, Ghassem, 14052 Berlin (DE)
(74) Vertreter: Tappe, Hartmut
(86) Internationale Anmeldenummer: PCT/DE2005/001230
(87) Internationale Veröffentlichungsnummer: WO 2006/005327

(56) Entgegenhaltungen:
- US-A- 4 752 180
- US-A1- 2003 211 704
- US-A1- 2004 014 298

## Beschreibung

Die vorliegende Erfindung betrifft ein Verfahren zur wechselseitigen Kontaktierung von zwei waferartigen Bauelement-Verbundanordnungen nach dem Oberbegriff des Anspruchs 1. Darüber hinaus betrifft die Erfindung eine zur Durchführung des Verfahrens besonders geeignete Vorrichtung nach dem Oberbegriff des Anspruchs 7.

Das Verfahren bzw. die Vorrichtung der vorgenannten Art kommt ganz allgemein dann zur Anwendung, wenn es darum geht, in einem Verbund zusammenhängend ausgebildete Substrate mit ebenfalls in einem Verbund angeordneten Bauelementen ohne vorhergehende Auflösung des jeweiligen Verbunds miteinander zu verbinden.

Zur Herstellung elektronischer Baugruppen auf Chipebene, beispielsweise Chips, die mit über die Chips angesteuerten Funktionsbauelementen, wie Laserdioden, kontakticrt sind, ist es bekannt, sowohl den Chip als auch die Laserdiode auf Waferebene, also in einem zusammenhängenden Waferverbund, herzustellen und anschließend vor Kontaktierung der Chips mit den Laserdioden sowohl die Chips als auch die Laserdioden aus dem jeweiligen Waferverbund zu vereinzeln. Hieraus ergibt sich die Notwendigkeit, einen zur Kontaktierung der Chips mit den Laserdioden notwendigen Positionierungs- und Verbindungsvorgang entsprechend der Anzahl der Chips bzw. der Laserdioden separat und wiederholt durchzuführen.

Die Vorteile, eine derartige Kontaktierung auf Waferebene durchführen zu können, um etwa den notwendigen Positionierungs- und Verbindungsvorgang für eine Vielzahl von im Verbund angeordneten Laserdioden bzw. Chips nur einmal durchzuführen, sind offensichtlich. Aufgrund der relativ großflächigen Verteilung der einzelnen miteinander zu verbindenden Kontaktmetallisierungen von Chips und Laserdioden erweist es sich jedoch als schwierig, über die gesamte Waferoberfläche ein einheitliches Spaltmaß einzustellen. Die Folge hiervon können fehlerhafte Kontaktierungen einzelner Paarungen von Kontaktmetallisierungen sein.

Aus der US 4,752,180 ist ein Verfahren und eine Vorrichtung zur Kontaktierung von Wafern bekannt, bei dem bzw, der der für die Kontaktierung erforderliche Kontaktdruck über formelastische Rückstellkräfte eines Wafers erzeugt wird.

Die US 2004/0014298 A1 zeigt ein Verfahren und eine Vorrichtung, bei dem bzw. der der für die Kontaktierung notwendige Kontaktdruck über eine sich lokal ändernde Positionierung eines auf den Waferverbund wirkenden Kontaktpins erfolgt.

Der vorliegenden Erfindung liegt die Aufgabe zugrunde, ein Verfahren bzw. eine Vorrichtung zur Herstellung elektronischer Baugruppen auf Waferebene vorzuschlagen, das bzw. die die Ausbildung eines einheitlichen Spaltmaßes zwischen den zu kontaktierenden Wafern ermöglicht.

Zur Lösung dieser Aufgabe weist das erfindungsgemäße Verfahren die Merkmale des Anspruchs 1 sowie die erfindungsgemäße Vorrichtung die Merkmale des Anspruchs 7 auf.

Bei dem erfindungsgemäßen Verfahren wird der für die Kontaktierung notwendige Kontaktdruck zwischen den miteinander zu verbindenden Kontaktmetallisierungen durch Ausbildung eines Vakuums in einem die Bauelement-Verbundanordnungen aufnehmenden Kontaktraum erzeugt. Die anschließende Kontaktierung der Kontaktmetallisierungen erfolgt durch eine rückwärtige Energiebeaufschlagung einer Bauelement-Verbundanordnung.

Die Ausbildung des Vakuums in dem Kontaktraum sorgt für eine koplanare Anordnung der Bauelement-Verbundanordnungen, ohne dass im Vergleich mit einer Druckbeaufschlagung zur Erzeugung des notwendigen Kontaktdrucks das spezifische Biegeverhalten der Wafer bzw. von Vorrichtungen, auf denen die Wafer angeordnet sind, berücksichtigt werden müsste.

Insbesondere ist es nicht notwendig, wie es bei einer Druckbeaufschlagung der Wafer der Fall wäre, Maßnahmen zu treffen, das Biegeverhalten bzw. eine Abweichung der Biegelinie von einer Geraden bei den Wafern zu kompensieren.

Weiterhin lassen sich beliebig hohe, lediglich von der Bauteilfestigkeit begrenzte Kontaktdrücke zwischen den Wafern über die Einstellung des Vakuums einstellen, ohne dass ein zusätzlicher apparativer Aufwand durch mechanische oder hydraulische Andruckvorrichtungen notwendig wäre.

Das erfindungsgemäße Verfahren lässt sich besonders vorteilhaft zur Herstellung sogenannter "SAW(Surface Acoustic Wave)-Filter" auf Waferebene einsetzen. Bei diesen Baugruppen sind Deckelchips zur Erzielung einer vakuumdichten Verbindung mit Trägerchips zusätzlich zu den elektrischen Kontaktierungen über eine hermetisch abdichtende periphere Kontaktmetallisierung mit den Trägerchips verbunden.

Bei einer besonders vorteilhaften Variante des Verfahrens wird der Kontaktraum durch Herstellung einer vakuumdichten Verbindung zwischen den die Bauelement-Verbundanordnungen mit ihren Kontaktmetallisierungen einander gegenüberliegend aufnehmenden Aufnahmeeinrichtungen erzeugt. Hierdurch ist es möglich, den Kontaktraum mit einer geringst möglichen Anzahl von Bauteilen zu realisieren, wobei den ohnehin vorhandenen Aufnahmeeinrichtungen lediglich eine Dichtungseinrichtung hinzugefügt wird.

Eine Energiebeaufschlagung des vorausgehend zur thermischen Kontaktierung, also zur Ausführung der Bondverbindung, durch die Vakuumbeaufschlagung im Kontaktraum ausgebildeten kraftschlüssigen Verbunds der Bauelement-Verbundanordnungen wird in verfahrenstechnisch besonders einfacher Art und Weise durch eine Energiebeaufschlagung des Verbunds über eine Aufnahmeeinrichtung ermöglicht. Hierdurch kann in besonderer Weise der zur Durchführung des Verfahrens notwendige apparative Aufwand reduziert werden, da etwa auf eine Ofeneinrichtung, in die der im Kontaktraum angeordnete Verbund einzubringen wäre, verzichtet werden kann.

Eine besonders einfache Art der Energiebeaufschlagung kann dadurch erfolgen, dass die Energiebeaufschlagung durch Ausbildung der Aufnahmeeinrichtung als Beheizungseinrichtung erfolgt.

Alternativ ist es möglich, die Energiebeaufschlagung durch eine Kontaktbeheizung der Aufnahmeeinrichtung durchzuführen, so dass die Aufnahmeeinrichtung lediglich zur Wärmeeinleitung in den im Kontaktraum geschaffenen Verbund der Bauelement-Verbundanordnungen dient.

Bei einer weiteren vorteilhaften Ausgestaltung des Verfahrens erfolgt die Energiebeaufschlagung durch eine Strahlungsbeaufschlagung der Aufnahmeeinrichtung. Hierbei ist es in vorteilhafter Weise möglich, das Material der Aufnahmeeinrichtung und die Art der Strahlungsquelle aufeinander abzustimmen, so dass beispielsweise bei Auswahl eines absorbierenden Materials für die Aufnahmeeinrichtung eine Infrarotstrahlungsquelle oder bei Auswahl eines optisch transparenten Materials für die Aufnahmeeinrichtung eine Laserstrahlungsquelle eingesetzt werden kann.

Die erfindungsgemäße Vorrichtung weist eine erste Aufnahmeeinrichtung zur Aufnahme der ersten Bauelement-Verbundanordnung und eine zweite Aufnahmeeinrichtung zur Aufnahme der zweiten Bauelement-Verbundanordnung, eine Dichtungseinrichtung zur abdichtenden Verbindung der Aufnahmeeinrichtungen miteinander und Ausbildung eines die Bauelement-Verbundanordnungen umschließenden druckdichten Kontaktraums, eine Anschlusseinrichtung zum Anschluss einer Vakuumeinrichtung an den Kontaktraum und eine Energiebeaufschlagungseinrichtung zur rückwärtigen Energiebeaufschlagung zumindest einer Bauelement-Verbundanordnung über eine Aufnahmeeinrichtung auf. Bei der erfindungsgemäßen Vorrichtung wird demnach der zur Erzeugung eines zwischen den Bauelement-Verbundanordnungen wirkenden Vakuums notwendige Kontaktraum durch die abdichtende Verbindung der Aufnahmeeinrichtungen miteinander ermöglicht.

Als besonders vorteilhaft erweist es sich, wenn die Dichtungseinrichtung zumindest in einem Verbindungsbereich zwischen den Aufnahmeeinrichtungen elastisch ausgebildet ist. Diese Elastizität kann sowohl durch eine entsprechende Materialauswahl für die Dichtungseinrichtung als auch durch eine formelastische Gestaltung der Dichtungseinrichtung erzielt werden. Wesentlich ist hierbei, dass die Dichtungseinrichtung zum einen die Ausbildung des vakuumdichten Kontaktraums ermöglicht, zum anderen die Ausbildung des Kontaktdrucks zwischen den einander gegenüberliegend angeordneten Kontaktmetallisierungen der Bauelement-Verbundanordnungen nicht behindert.

Gemäß einer vorteilhaften Ausführungsform weist die Dichtungseinrichtung einen Dichtungskörper mit einer von einer Starrkörpereinrichtung gebildeten Dichtfläche auf. Hierdurch ist es möglich, einerseits die für die Funktion der Vorrichtung notwendige Elastizität zu realisieren, andererseits eine Gestaltung der Dichtfläche zu ermöglichen, die sich im Betrieb als möglichst abnutzungsfrei erweist.

Wenn die Starrkörpereinrichtung aus einem die erste Aufnahmeeinrichtung peripher umgebenden und mit dieser Aufnahmeeinrichtung verbundenen Dichtring besteht, der mit seiner Dichtfläche plan gegen die zweite Aufnahmeeinrichtung anliegt, kann einerseits eine sichere Abdichtung realisiert werden, andererseits kann über den Dichtungskörper leicht eine Abweichung in der Parallelität zwischen den Aufnahmeeinrichtungen kompensiert werden.

Eine Ausführung der Vorrichtung mit einem Dichtungskörper, der die nutzbare Fläche der Aufnahmeeinrichtung zur Anordnung der Bauelement-Verbundanordnung nicht beeinträchtigt, wird möglich, wenn der Dichtungskörper aus einer Materialbahn eines elastischen, gasdichten Materials gebildet ist und mit dem Umfang der Aufnahmeeinrichtung verbunden ist.

Auf eine abdichtende Verbindung zwischen dem Dichtungskörper und der Aufnahmeeinrichtung kann verzichtet werden, wenn der Dichtungskörper sich über die Rückseite der Aufnahmeeinrichtung erstreckt und somit die Aufnahmeeinrichtung rückseitig umschließt.

Wenn die Aufnahmeeinrichtung unter zwischenliegender Anordnung einer elastischen Ausgleichseinrichtung mit einer Handhabungseinrichtung versehen ist, ist sichergestellt, dass sich Parallelitätsabweichungen zwischen der Handhabungseinrichtung und der Aufnahmeeinrichtung nicht nachteilig auf den Kontaktdruck zwischen den Bauelement-Verbundanordnungen auswirken.

Eine besonders kompakte Ausführung der Vorrichtung wird möglich, wenn die zweite Aufnahmeeinrichtung zur Ausbildung einer Energiebeaufschlagungseinrichtung als eine Kontaktplatte zur Kontaktbeheizung mittels einer Kontaktbeheizungseinrichtung ausgebildet ist, da somit die Vorrichtung unabhängig von einer Beheizungseinrichtung ausgebildet werden kann und zur Wärmebeaufschlagung der Bauelement-Verbundanordnung lediglich in Kontakt mit einer Beheizungseinrichtung zu bringen ist.

Alternativ ist es möglich, die zweite Aufnahmeeinrichtung zur Ausbildung einer Energiebeaufschlagungseinrichtung als eine zumindest bereichsweise strahlungstransparente Platte auszubilden.

Eine insgesamt kompakte Ausgestaltung der Vorrichtung mit quasi integrierter Beheizungseinrichtung wird möglich, wenn die zweite Aufnahmeeinrichtung zur Ausbildung einer Energiebeaufschlagungseinrichtung als Kontaktheizung ausgebildet ist.

Eine besonders einfach zu realisierende Ausführung der Aufnahmeeinrichtung als Kontaktheizung besteht in einer Ausgestaltung der Aufnahmeeinrichtung als Widerstandsheizung.

Wenn die als Widerstandsheizung ausgebildete Aufnahmeeinrichtung als elektrische Widerstandsfolie ausgebildet ist, ergibt sich eine besonders leichtgewichtige und zugleich schnell wirkende Beheizungsmöglichkeit für die Bauelement-Verbundanordnung.

Nachfolgend werden bevorzugte Varianten des Verfahrens unter Erläuterung bevorzugter Ausführungsformen der hierzu verwendeten Vorrichtung anhand der Zeichnung näher dargestellt. Es zeigen:
- **Fig. 1**: eine Waferbondvorrichtung vor Herstellung eines Kontaktverbunds zwischen zwei jeweils auf einer Aufnahmeeinrichtung angeordneten Wafern;
- **Fig. 2**: die Waferbondvorrichtung mit dem in einem Kontaktraum hergestellten Waferverbund;
- **Fig. 3**: die unter Mitnahme des Waferverbunds von einer Arbeitsplattform abgehobene Waferbondvorrichtung;
- **Fig. 4**: die Waferbondvorrichtung mit dem Waferverbund vor der Positionierung auf einer Kontaktheizung;
- **Fig. 5**: die auf der Kontaktheizung positionierte Waferbondvorrichtung zur Durchführung der Bondverbindung zwischen Kontaktmetallisierungen der Wafer;
- **Fig. 6**: eine Durchführung der Bondverbindung mittels Laserbeaufschlagung;
- **Fig. 7**: eine Durchführung der Bondverbindung mittels einer als Widerstandsfolie ausgebildeten Aufnahmeeinrichtung.

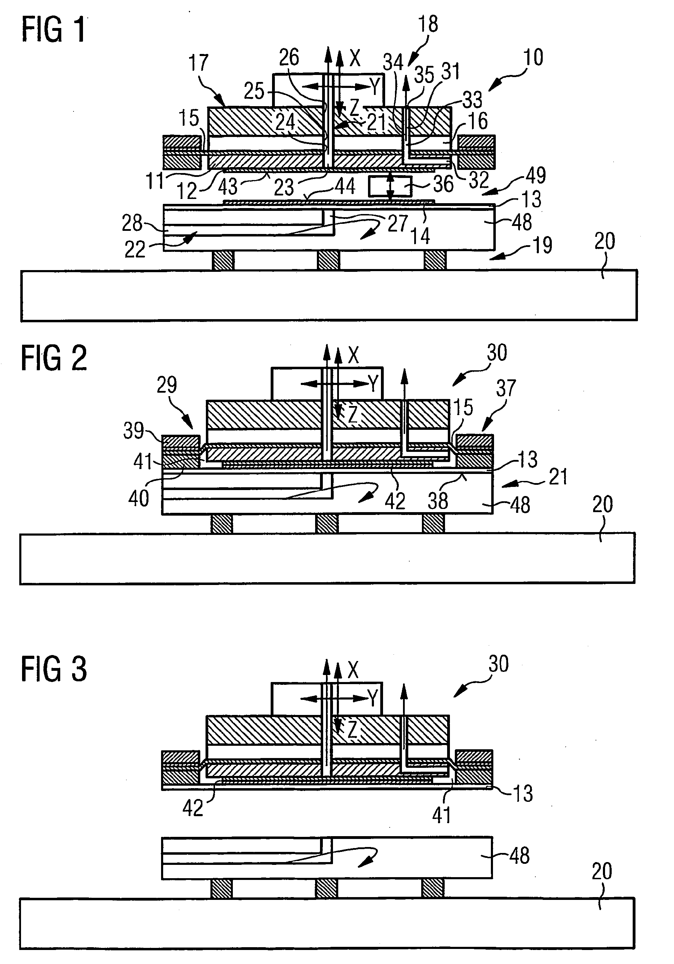

**Fig. 1** zeigt eine Waferbondvorrichtung 10 mit einer ersten Aufnahmeeinrichtung 11 zur Anordnung eines ersten Wafers 12 und einer zweiten Aufnahmeeinrichtung 13 zur Anordnung eines zweiten Wafers 14. Die Aufnahmeeinrichtung 11 besteht im vorliegenden Fall aus einer Metallplatte und ist unter zwischenliegender Anordnung eines flächigen, hier aus einer Folienbahn gebildeten elastischen Dichtungskörpers 15 einer Dichtungseinrichtung 15 und einer Zwischenlage 16 mit elastisch federnden Eigenschaften mit einer Handhabungseinrichtung 17 verbunden. Die Handhabungseinrichtung 17 ist mit einer dreiachsig wirkenden Steuereinrichtung 18 versehen, die eine räumliche Positionierung des an der Aufnahmeeinrichtung 11 angeordneten Wafers 12 gegenüber dem auf der Aufnahmeeinrichtung 13 angeordneten Wafer 14 ermöglicht.

Wie **Fig. 1** ferner zeigt, ist die Aufnahmeeinrichtung 13 auf einer Arbeitsplattform 48 angeordnet, die sich im vorliegenden Fall unter zwischenliegender Anordnung einer elastischen Abstützungseinrichtung 19 auf einem Basisgestell 20 befindet.

Wie **Fig. 1** ferner zeigt, ist sowohl die mit der Handhabungseinrichtung 17 verbundene Aufnahmeeinrichtung 11 als auch die auf der Arbeitsplattform 48 angeordnete Aufnahmeeinrichtung 13 mit einer Anschlusseinrichtung 21 bzw. 22 zum Anschluss an jeweils eine hier nicht näher dargestellte Vakuumpumpe versehen. Zur Ausbildung der Anschlusseinrichtung 21 weist die Aufnahmeeinrichtung 11 eine Bohrung 23 auf, die fluchtend mit einer Bohrung 24 im Dichtungskörper 15, einer Bohrung 25 in der Zwischenlage 16 und einer Bohrung 26 in der Handhabungseinrichtung 17 angeordnet ist. Die Aufnahmeeinrichtung 13 weist eine Bohrung 27 auf, die in einen in der Arbeitsplattform 48 ausgebildeten Kanal 28 übergeht. Die außenliegende Bohrung 26 in der Handhabungseinrichtung 17und der Kanal 28 in der Arbeitsplattform 48 sind jeweils für den Anschluss an die nicht dargestellten Vakuumpumpen vorgesehen.

Die in **Fig. 1** oberhalb und mit Abstand zur Aufnahmeeinrichtung 13 bzw. zu dem darauf angeordneten Wafer 14 dargestellte Handhabungseinheit aus der Handhabungseinrichtung 17 und der damit unter zwischenliegender Anordnung der Dichtungseinrichtung 29 und der Zwischenlage 16 verbundenen Aufnahmeeinrichtung 11 soll nachfolgend als Bondkopf 30 bezeichnet werden. Der Bondkopf 30 weist eine weitere Anschlusseinrichtung 31 zum Anschluss an eine hier nicht näher dargestellte weitere Vakuumpumpe auf, die über eine Bohrung 32 in der Aufnahmeeinrichtung 11, eine Bohrung 33 im Dichtungskörper 15, eine Bohrung 34 in der Zwischenlage 16 und eine Bohrung 35 in der Handhabungseinrichtung 17 den äußeren Anschluss der Vakuumpumpe ermöglicht.

In einem Verfahren zur Herstellung einer Bondverbindung zwischen den beiden Wafern 12, 14 zeigt **Fig. 1** eine Phase unmittelbar vor der wechselseitigen Kontaktierung von hier nicht näher dargestellten, auf Kontaktflächen 43, 44 einander gegenüberliegenden Kontaktmetallisierungen der Wafer 12, 14. Der in **Fig. 1** dargestellten Phase vorausgegangen ist eine Aufnahme des Wafers 12 durch den Bondkopf 30 durch eine Vakuumbeaufschlagung des Wafers 12 über den über dem Wafer 12 positionierten Bondkopf 30 und eine Positionierung des Bondkopfs 30 über den zuvor auf der Arbeitsplattform 48 angeordneten und ebenfalls mittels Vakuumbeaufschlagung auf der Aufnahmeeinrichtung 13 fixierten Wafer 14.

In der in **Fig. 1** dargestellten Phase erfolgt dann eine relative Ausrichtung des Bondkopfs 30 gegenüber der Arbeitsplattform 48, derart, dass die miteinander zu kontaktierenden Kontaktmetallisierungen der Wafer 12, 14 in eine Überdeckungslage gebracht werden. Hierzu erfolgt eine Ansteuerung des Bondkopfs 30 über die Steuereinrichtung 18 in Abhängigkeit von einer hier nicht näher erläuterten Bildverarbeitungseinrichtung, deren Eingangssignale von einer in einem Waferzwischenraum 48 angeordneten Kameraeinrichtung 36 stammen.

Nach Einstellung der Überdeckungslage zwischen den Kontaktmetallisierungen der Wafer 12, 14 und Entfernung der Kameraeinrichtung 36 aus dem Waferzwischenraum 49 erfolgt ein Verfahren des Bondkopfs 30 gegen die Arbeitsplattform 48 bis zum Erreichen eines mechanischen Kontakts zwischen den miteinander zu kontaktierenden Kontaktmetallisierungen der Wafer 12 und 14. Bei Erreichen des Kontakts legt sich ein in Fig. 2 dargestellter, mit dem Dichtungskörper 15 gasdicht verbundener Dichtring 37 der Dichtungseinrichtung 29 mit seiner kreisringförmigen Dichtfläche 38 gegen die in dem hier dargestellten Ausführungsbeispiel durch eine Stahlplatte gebildete, auf der Arbeitsplattform 48 angeordnete Aufnahmeeinrichtung 13 an. Der Dichtring 37 besteht in dem hier dargestellten Ausführungsbeispiel aus zwei Metallringen 39, 40, die den peripheren Rand des Dichtungskörpers 15 zwischen sich aufnehmen.

In der in **Fig. 2** dargestellten Konfiguration wird durch den Kontakt des Dichtrings 37 mit der Aufnahmeeinrichtung 13 ein von den Aufnahmeeinrichtungen 11, 13 begrenzter und durch die Dichtungseinrichtung 29 abgedichteter Kontaktraum 41 gebildet, der einen aus den Wafern 12 und 14 gebildeten Waferverbund 42 in sich aufnimmt. Nach Ausbildung des in **Fig. 2** dargestellten Kontaktraums 41 kann dieser über die im Bondkopf 30 ausgebildete und über die Aufnahmeeinrichtung 13 in den Kontaktraum 41 einmündende Anschlusseinrichtung 31 evakuiert werden.

Durch Ausbildung des Vakuums im Kontaktraum 41 werden die Wafer 12, 14 des Waferverbunds 42 gegeneinander gedrückt, so dass sich je nach Höhe des eingestellten Vakuums der für einen nachfolgenden thermischen Verbindungsvorgang zwischen den Kontaktmetallisierungen notwendige Kontaktdruck einstellen lässt. Sollten Parallelitätsabweichungen zwischen den Oberflächen der Aufnahmeeinrichtungen 11, 13 bestehen, so werden diese durch die zwischen der Aufnahmeeinrichtung 11 bzw. dem Dichtungskörper 15 der Dichtungseinrichtung 29 und der Handhabungseinrichtung 17 angeordnete elastische Zwischenlage 16 kompensiert, so dass in jedem Fall eine koplanare Anordnung der Kontaktoberflächen 43, 44 der Wafer 12, 14 bzw. die Ausbildung eines über die Kontaktoberflächen konstanten Spaltmaßes zwischen den Wafern 12, 14 im Waferverbund 42 gewährleistet ist.

Nach Einstellung des gewünschten Kontaktdrucks zwischen den Wafern 12, 14 des Waferverbunds 42 im Kontaktraum 41 wird das über die in der Arbeitsplattform 48 ausgebildete Anschlusseinrichtung 22 rückwärtig am Wafer 14 anliegende Vakuum abgeschaltet, so dass, wie in **Fig. 3** dargestellt, der Bondkopf 30 zusammen mit der Aufnahmeeinrichtung 13 von der Arbeitsplattform 48 unter Aufrechterhaltung des im Kontaktraum 41 ausgebildeten Waferverbunds 42 abgehoben werden kann.

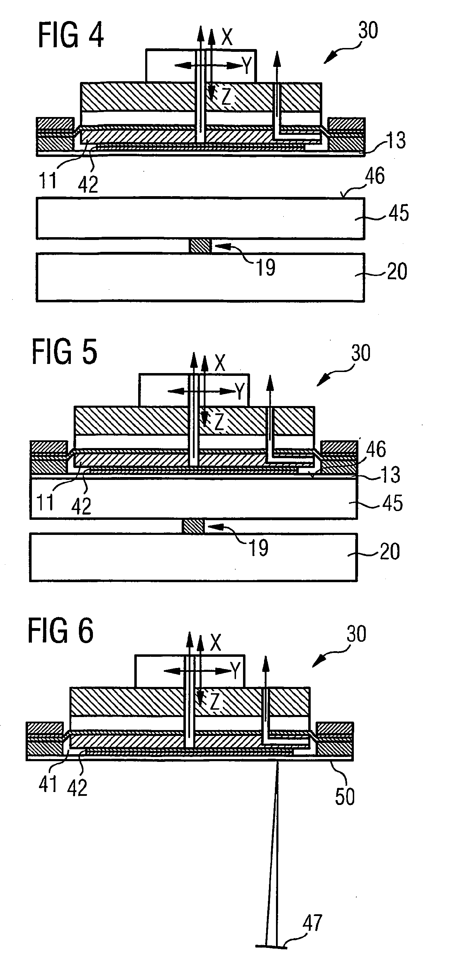

Wie in den **Fig. 4** und 5 dargestellt, wird nun nachfolgend der Bondkopf 30 über eine vorgeheizte Kontaktbeheizungseinrichtung 45 positioniert und auf diese abgesenkt, so dass die Aufnahmeeinrichtung 13 zur Ermöglichung eines Wärmeübergangs auf die Kontaktbeheizungseinrichtung 45 abgesetzt wird. Entsprechend dem gewünschten Temperaturprofil erfolgt nun ein Aufheizvorgang auf die gewünschte Bondtemperatur, zu deren Überwachung in der Aufnahmeeinrichtung 11 des Bondkopfs 30 ein hier nicht näher dargestellter Temperatursensor vorgesehen sein kann. Sollte ein Halten der Bondtemperatur über eine definierte Zeitdauer beabsichtigt sein, so kann die in **Fig. 5** dargestellte Anordnung noch mit einer hier nicht näher dargestellten Abstandsregelungseinrichtung versehen sein, die nach Erreichen der Bondtemperatur die Einstellung bzw. Änderung eines Abstandes zwischen der Aufnahmeeinrichtung 13 und einer Kontaktoberfläche 46 der Kontaktbeheizungseinrichtung 45 zur Aufrechterhaltung der Bondtemperatur über eine bestimmte Zeitdauer ermöglicht.

Alternativ zur vorstehend erläuterten Positionierung des Bondkopfs 30 auf der Kontaktbeheizungseinrichtung 45 ist es auch möglich, die in **Fig. 1** dargestellte Arbeitsplattform 48 beheizt auszubilden und die Kontaktbeheizung in der in **Fig.1** dargestellten Konfiguration durchzuführen.

Sollte eine gezielte Abkühlung gewünscht sein, so kann nachfolgend eine Abkühlung durch Positionierung des Bondkopfs 30 auf einer hier nicht näher dargestellten Kontaktkühlungseinrichtung erfolgen.

Darüber hinaus ist es auch möglich, den Bondkopf 30 mittels einer durch den Vakuumkanal 26 oder gesonderte Kühlkanäle geleiteten Kühlmittelströmung, insbesondere einer Luftströmung, zu kühlen.

Um zu verhindern, dass sich eine Parallelitätsabweichung zwischen der Kontaktoberfläche 46 der Kontaktbeheizungseinrichtung 45 und der Aufnahmeeinrichtung 13 auf den Waferverbund 42 auswirkt, kann, wie in den **Fig. 4** und **5** dargestellt, ähnlich wie in der Anordnung gemäß den **Fig. 1** bis **3** zwischen dem Basisgestell 20 und der Kontaktbeheizungseinrichtung 45 eine elastische Abstützeinrichtung 19 vorgesehen sein.

Während der in **Fig. 5** beispielhaft dargestellten Bondphase, in der eine thermische Verbindung zwischen den Kontaktmetallisierungen der Wafer 12 und 14 erfolgt, ist es bei Bedarf auch möglich, den durch das Vakuum im Kontaktraum 41 erzeugten Kontaktdruck durch eine Druckbeaufschlagung des Waferverbunds 42 mit dem Bondkopf noch zu erhöhen. Dabei verhindert die Vakuumfixierung der Wafer 12 und 14 gegeneinander eine ansonsten durch die Druckbeaufschlagung mögliche Gleitbewegung der Wafer 12, 14 aufeinander.

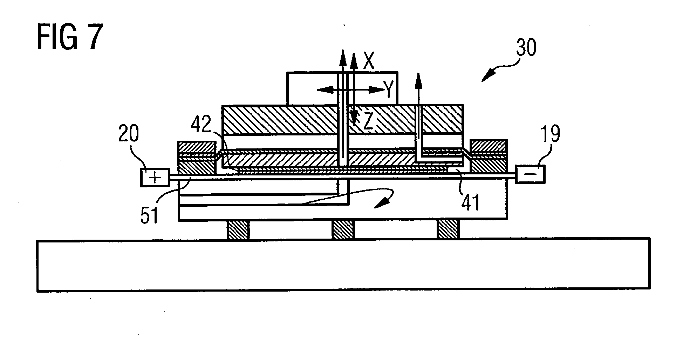

In den **Fig. 6** und **7** sind alternative Möglichkeiten zur Beheizung des im Kontaktraum 41 am Bondkopf 30 angeordneten Waferverbunds 42 dargestellt. **Fig. 6** zeigt die Beheizung mittels einer selektiven Energiebeaufschlagung der Kontaktmetallisierungen über eine verschwenkbare Laseremissionseinrichtung 47, wobei hierzu eine Aufnahmeeinrichtung 50 aus einem für die Laserstrahlung transparenten Material ausgebildet ist. Bei einer Ausbildung der Aufnahmeeinrichtung aus einem strahlungs- bzw. wärmeabsorbierenden Material, wie beispielsweise Silicium, könnte eine Beheizung des Waferverbunds mittels Wärmeleitung erfolgen.

Bei einer weiteren, hier nicht näher dargestellten Ausführungsform des Bondkopfs kann dieser auch mit einer integrierten Laseremissionseinrichtung versehen sein, so dass abweichend von dem in **Fig. 6** dargestellten Ausführungsbeispiel die Beheizung des Waferverbunds über die dem Bondkopf zugewandte Aufnahmeeinrichtung erfolgt.

**Fig. 7** zeigt eine am Bondkopf 30 angeordnete, als elektrisch beheizbare Widerstandsfolie ausgebildete Aufnahmeeinrichtung 51. Eine derart unmittelbar beheizbare Aufnahmeeinrichtung ermöglicht die Herstellung der thermischen Bondverbindung zwischen den Kontaktmetallisierungen der Wafer 12, 14 des Waferverbunds 42 am Bondkopf 30 selbst, ohne dass eine separate Beheizungseinrichtung vorgesehen werden müsste.

## Patentansprüche

1. Verfahren zur wechselseitigen Kontaktierung von zwei waferartigen Bauelement-Verbundanordnungen (12, 14) aus einer Vielzahl zusammenhängend ausgebildeter gleichartiger Bauelemente, insbesondere eines Halbleiter-Wafers mit einem Funktionsbauelement-Wafer, zur Herstellung von elektronischen Baugruppen auf Waferebene, bei dem die Bauelement-Verbundanordnungen jeweils auf einer Aufnahmeeinrichtung (11; 13, 50, 51) angeordnet werden,
**dadurch gekennzeichnet,**
**dass** der für die Kontaktierung notwendige Kontaktdruck zwischen miteinander zu verbindenden Kontaktmetallisierungen der Bauelement-Verbundanordnungen derart erzeugt wird, dass in einem die Bauelement-Verbundanordnungen aufnehmenden, durch die Aufnahmeeinrichtungen begrenzten Kontaktraum (41) ein Vakuum erzeugt wird, und die Kontaktierung der Kontaktmetallisierungen durch eine rückwärtige Energiebeaufschlagung einer Bauelement-Verbundanordnung erfolgt.

2. Verfahren nach Anspruch 1,
**dadurch gekennzeichnet,**
**dass** der Kontaktraum (41) durch Herstellung einer vakuumdichten Verbindung zwischen den die Bauelement-Verbundanordnungen (12, 14) mit ihren Kontaktmetallisierungen einander gegenüberliegend aufnehmenden Aufnahmeeinrichtungen (11; 13, 50, 51)erzeugt wird,

3. Verfahren nach Anspruch 1 oder 2,
**dadurch gekennzeichnet,**
**dass** zur Ausbildung der Kontaktierung ein durch eine Vakuumbeaufschlagung im Kontaktraum (41) ausgebildeter Verbund (42) der Bauelement-Verbundanordnungen (12, 14) über eine Aufnahmceinrichtung (11; 13, 50, 51) mit Energie beaufschlagt wird.

4. Verfahren nach Anspruch 3,
**dadurch gekennzeichnet,**
**dass** die Energiebeaufschlagung durch Ausbildung der Aufnahmeeinrichtung (51) als Beheizungseinrichtung erfolgt.

5. Verfahren nach Anspruch 3
**dadurch gekennzeichnet,**
**dass** die Energiebeaufschlagung durch eine Kontaktbeheizung der Aufnahmeeinrichtung (13) erfolgt.

6. Verfahren nach Anspruch 3,
**dadurch gekennzeichnet,**
**dass** die Energiebeaufschlagung durch eine Strahlungsbeaufschlagung der Aufnahmeeinrichtung (50) erfolgt.

7. Vorrichtung zur wechselseitigen Kontaktierung von zwei waferartigen Bauelement-Verbundanordnungen (12, 14) aus einer Vielzahl zusammenhängend ausgebildeter gleichartiger Bauelemente, insbesondere eines Halbleiter-Wafers mit einem Funktionsbauelement-Wafer zur Herstellung von elektronischen Baugruppen auf Waferebene mit einer ersten Aufnahmeeinrichtung (11) zur Aufnahme der ersten Bauelement-Verbundanordnung (12) und einer zweiten Aufnahmeeinrichtung (13) zur Aufnahme der zweiten Bauelement-Verbundanordnung (14),
**gekennzeichnet durch**
eine Dichtungseinrichtung (29) zur abdichtenden Verbindung der Aufnahmeeinrichtungen miteinander und Ausbildung eines die Bauelement-Verbundanordnungen umschließenden druckdichten Kontaktraums (41), eine Anschlusseinrichtung (21, 22) zum Anschluss einer Vakuumeinrichtung an den Kontaktraum und eine Energiebeaufschlagungseinrichtung zur rückwärtigen Energiebeaufschlagung einer Bauelement-Verbundanordnung über die zweite Aufnahmeeinrichtung.

8. Vorrichtung nach Anspruch 7,
**dadurch gekennzeichnet,**
**dass** die Dichtungseinrichtung (29) zumindest in einem Verbindungsbereich zwischen den Aufnahmeeinrichtungen (11,; 13, 50, 51) elastisch ausgebildet ist.

9. Vorrichtung nach Anspruch 8,
**dadurch gekennzeichnet,**
**dass** die Dichtungseinrichtung (29) einen elastischen Dichtungskörper (15) mit einer von einer Starrkörpereinrichtung gebildeten Dichtfläche (38) aufweist.

10. Vorrichtung nach Anspruch 9,
**dadurch gekennzeichnet,**
**dass** die Starrkörpereinrichtung aus einem die erste Aufnahmeeinrichtung (11) peripher umgebenden und mit der Aufnahmeeinrichtung über den Dichtungskörper (15) verbundenen Dichtring (37) besteht, der mit seiner Dichtfläche (38) plan gegen die zweite Aufnahmeeinrichtung (13; 50, 51) anliegt.

11. Vorrichtung nach einem der Ansprüche 9 oder 10,
**dadurch gekennzeichnet,**
**dass** der Dichtungskörper (15) aus einer Materialbahn eines elastischen, gasdichten Materials besteht und mit dem Umfang der Aufnahmeeinrichtung (11) verbunden ist.

12. Vorrichtung nach Anspruch 9 oder 10,
**dadurch gekennzeichnet,**
**dass** der Dichtungskörper (15) sich über eine Rückseite der Aufnahmeeinrichtung (11) erstreckt.

13. Vorrichtung nach Anspruch 11 oder 12,
**dadurch gekennzeichnet,**
**dass** die Aufnahmeeinrichtung (11) unter zwischenliegender Anordnung einer elastischen Ausgleichseinrichtung (16) mit einer Handhabungseinrichtung (17) versehen ist.

14. Vorrichtung nach einem der Ansprüche 7 bis 13,
**dadurch gekennzeichnet,**
**dass** die zweite Aufnahmeeinrichtung (13) als eine Kontaktplatte zur Kontaktbeheizung mittels einer Kontaktbeheizungseinrichtung (45) ausgebildet ist.

15. Vorrichtung nach einem der Ansprüche 7 bis 13,
**dadurch gekennzeichnet,**
**dass** die zweite Aufnahmeeinrichtung (50) als eine zumindest bereichsweise strahlungstransparente Platte ausgebildet ist.

16. Vorrichtung nach einem der Ansprüche 7 bis 13,
**dadurch gekennzeichnet,**
**dass** die zweite Aufnahmeeinrichtung (51) als Kontaktheizung ausgebildet ist.

17. Vorrichtung nach Anspruch 16,
**dadurch gekennzeichnet,**
**dass** die zweite Aufnahmeeinrichtung als Widerstandsheizung ausgebildet ist.

18. Vorrichtung nach Anspruch 17,
**dadurch gekennzeichnet,**
**dass** die zweite Aufnahmeeinrichtung als elektrische Widerstandsfolie ausgebildet ist.

## Claims

1. A method for the mutual contacting of two wafer-type component composite configurations (12, 14) made of multiple identical components implemented coherently, in particular a semiconductor wafer with a functional component wafer, to produce electronic assemblies on the wafer level, in which each of the component composite configurations is situated on a receptacle unit (11; 13, 50, 51)
**characterized in that**
the contact pressure required for the contacting between contact metallizations of the component composite configurations to be connected to one another is generated in such a way that a vacuum is generated in a contact chamber (41), which receives the component composite configurations and is delimited by the receptacle units, and the contacting of the contact metallizations is performed by a rear energy impingement of a component composite configuration.

2. The method according to Claim 1,
**characterized in that**
the contact chamber (41) is generated by producing a vacuum-tight connection between the receptacle units (11; 13, 50, 51), which receive the component composite configurations (12, 14) having their contact metallizations diametrically opposite one another.

3. The method according to Claim 1 or 2,
**characterized in that**
a composite (42) of the component composite configurations (12, 14), implemented by a vacuum impingement in the contact chamber (41), is impinged with energy via a receptacle unit (11; 13, 50, 51) to implement the contacting.

4. The method according to Claim 3,
**characterized in that**
the energy impingement is performed by implementing the receptacle unit (51) as a heating unit.

5. The method according to Claim 3,
**characterized in that**
the energy impingement is performed by contact heating of the receptacle unit (13).

6. The method according to Claim 3,
**characterized in that**
the energy impingement is performed by radiation impingement of the receptacle unit (50).

7. A device for the mutual contacting of two wafer-type component composite configurations (12, 14) made of multiple identical components which are implemented coherently, in particular a semiconductor wafer with a functional component wafer to produce electronic assemblies on the wafer level, having a first receptacle unit (11) to receive the first component composite configuration (12) and a second receptacle unit (13) to receive the second component composite configuration (14),
**characterized by**
a seal unit (29) for the sealed connection of the receptacle units to one another and for implementing a pressure-tight contact chamber (41) which encloses the component composite configurations, an attachment unit (21, 22) for attaching a vacuum unit to the contact chamber, and an energy impingement unit for the rear energy impingement of a component composite configuration via the second receptacle unit.

8. The device according to Claim 7,
**characterized in that**
the seal unit (29) is implemented as elastic at least in a connection area between the receptacle units (11; 13, 50, 51).

9. The device according to Claim 8,
**characterized in that**
the seal unit (29) has an elastic seal body (15) having a seal face (38) formed by a rigid body unit.

10. The device according to Claim 9,
**characterized in that**
the rigid body unit comprises a seal ring (37), which peripherally encloses the first receptacle unit (11) and is connected to the receptacle unit via the seal body (15), whose seal surface (38) presses flatly against the second receptacle unit (13; 50, 51).

11. The device according to one of Claims 9 or 10,
**characterized in that**
the seal body (15) comprises a material web made of an elastic, gas-tight material and is connected to the circumference of the receptacle unit (11).

12. The device according to Claim 9 or 10,
**characterized in that**
the seal body (15) extends over the rear of the receptacle unit (11).

13. The device according to Claim 11 or 12,
**characterized in that**
the receptacle unit (11) is provided with a handling unit (17), with an elastic equalization unit (16) being situated interposed.

14. The device according to one of Claims 7 to 13,
**characterized in that**
the second receptacle unit (13) is implemented as a contact plate for contact heating using a contact heating unit (45).

15. The device according to one of Claims 7 through 13,
**characterized in that**
the second receptacle unit (50) is implemented as an at least regionally radiation-transparent plate.

16. The device according to one of Claims 7 through 13,
**characterized in that**
the second receptacle unit (51) is implemented as a contact heater.

17. The device according to Claim 16,
**characterized in that**
the second receptacle unit is implemented as a resistance heater.

18. The device according to Claim 17,
**characterized in that**
the second receptacle unit is implemented as an electrical resistance film.

## Revendications

1. Procédé de contactage alternatif de deux dispositifs d'assemblage de composants de type tranche en silicium (12, 14) composés d'une pluralité de composants similaires à configuration solidarisée, notamment d'une tranche à semi-conducteurs avec une tranche de composants de fonctionnement, afin de produire des modules électroniques au niveau de la tranche, dans lequel les dispositifs d'assemblage de composants sont respectivement disposés sur un dispositif de réceptacle (11; 13, 50, 51),
**caractérisé en ce que**
la pression de contact requise en vue du contactage est produite entre les métallisations de contact des dispositifs d'assemblage de composants à relier les unes aux autres de telle sorte que, dans un espace de contact (41) renfermant les dispositifs d'assemblage de composants, délimité par les dispositifs de réceptacle, un vide est produit, et le contactage des métallisations de contact s'effectue par une sollicitation par de l'énergie arrière d'un dispositif d'assemblage de composants.

2. Procédé selon la revendication 1,
**caractérisé en ce que**
l'espace de contact (41) est produit en générant une liaison étanche au vide entre les dispositifs de réceptacle (11; 13, 50, 51) renfermant les dispositifs d'assemblage de composants (12, 14) dont les métallisations de contact se font mutuellement face.

3. Procédé selon la revendication 1 ou 2,
**caractérisé en ce que**
afin de réaliser le contact, un assemblage (42) des dispositifs d'assemblage de composants (12, 14) réalisé par une sollicitation par du vide dans la zone de contact (41) est sollicité par de l'énergie par l'intermédiaire d'un dispositif de réceptacle (11; 13, 50, 51).

4. Procédé selon la revendication 3,
**caractérisé en ce que**
la sollicitation par de l'énergie s'effectue en configurant le dispositif de réceptacle (51) comme un dispositif de chauffage.

5. Procédé selon la revendication 3,
**caractérisé en ce que**
la sollicitation par de l'énergie s'effectue par un chauffage de contact du dispositif de réceptacle (13).

6. Procédé selon la revendication 3,
**caractérisé en ce que**
la sollicitation par de l'énergie s'effectue par une sollicitation par un rayonnement du dispositif de réceptacle (50).

7. Dispositif de contactage alternatif de deux dispositifs d'assemblage de composants de type tranche en silicium (12,14) composés d'une pluralité de composants similaires à configuration solidarisée, notamment d'une tranche à semi-conducteurs avec une tranche à composants de fonctionnement, afin de produire des modules électroniques au niveau de la tranche comportant un premier dispositif de réceptacle (11) pour recevoir le premier dispositif d'assemblage de composants (12) et un deuxième dispositif de réceptacle (13) pour recevoir le deuxième dispositif d'assemblage de composants (14),
**caractérisé par**
un dispositif de joint d'étanchéité (29) pour relier de manière étanche les dispositifs de réceptacle les uns aux autres et réaliser un espace de contact (41) étanche à la pression enveloppant les dispositifs d'assemblage de composants, un dispositif de raccord (21, 22) pour raccorder un dispositif de vide à l'espace de contact et un dispositif de sollicitation par de l'énergie pour solliciter par de l'énergie arrière un dispositif d'assemblage de composants par l'intermédiaire du deuxième dispositif de réceptacle.

8. Dispositif selon la revendication 7,
**caractérisé en ce que**
le dispositif de joint d'étanchéité (29) a une configuration élastique au moins dans une zone de liaison entre les dispositifs de réceptacle (11; 13, 50, 51).

9. Dispositif selon la revendication 8,
**caractérisé en ce que**
le dispositif de joint d'étanchéité (29) présente un corps de joint d'étanchéité élastique (15) avec une surface d'étanchéité (38) formée par un dispositif de corps rigide.

10. Dispositif selon la revendication 9,
**caractérisé en ce que**
le dispositif de corps rigide est constitué d'une bague d'étanchéité (37) entourant la périphérie du premier dispositif de réceptacle (11) et reliée au dispositif de réceptacle par l'intermédiaire du corps de joint d'étanchéité (15), laquelle repose par sa surface d'étanchéité (38) à plat contre le deuxième dispositif de réceptacle (13; 50; 51).

11. Dispositif selon une des revendications 9 ou 10,
**caractérisé en ce que**
le corps de joint d'étanchéité (15) est constitué d'une bande de matériau d'un matériau élastique, étanche au gaz et est relié à la périphérie du dispositif de réceptacle (11).

12. Dispositif selon la revendication 9 ou 10,
**caractérisé en ce que**
le corps de joint d'étanchéité (15) s'étend sur un côté arrière du dispositif de réceptacle (11).

13. Dispositif selon la revendication 11 ou 12,
**caractérisé en ce que**
le dispositif de réceptacle (11) est pourvu d'un dispositif de manipulation (1) en intercalant un dispositif de compensation élastique (16).

14. Dispositif selon une des revendications 7 à 13,
**caractérisé en ce que**
le deuxième dispositif de réceptacle (13) est réalisé comme une plaque de contact en vue du chauffage de contact au moyen d'un dispositif de chauffage de contact (45).

15. Dispositif selon une des revendications 7 à 13,
**caractérisé en ce que**
le deuxième dispositif de réceptacle (50) est réalisé comme une plaque transparente au rayonnement sur au moins des portions.

16. Dispositif selon une des revendications 7 à 13,
**caractérisé en ce que**
le deuxième dispositif de réceptacle (51) est réalisé comme un chauffage de contact.

17. Dispositif selon la revendication 16,
**caractérisé en ce que**
le deuxième dispositif de réceptacle est réalisé comme un chauffage de résistance.

18. Dispositif selon la revendication 17,
**caractérisé en ce que**
le deuxième dispositif de réceptacle est réalisé comme un film de résistance électrique.
